# EUROPEAN PATENT APPLICATION

(11) **EP 4 819 794 A2**
(43) Date of publication of application: **07.10.2026**
(21) Application number: 26170297.1
(22) Date of filing: 01.04.2026
(51) Int. Cl.: H10D 62/10, H10D 30/67, H10D 30/00, H10D 30/01, H10D 30/60

(54) **DUAL GATE LDMOS DEVICES FOR GATE-ALL-AROUND PROCESS FLOWS**

(30) Priority: 02.04.2025 US 202519098708
(71) Applicant: Avago Technologies International Sales Pte. Limited, Singapore 768923 (SG)
(72) Inventor: Liu, Qing, Irvine, 92602 (US)
(74) Representative: Dilg, Haeusler, Schindelmann Patentanwaltsgesellschaft mbH

(57) **Abstract**

In an embodiment, a transistor has a semiconductor layer with a first-type region and a second-type region adjacent to the first-type region. An insulating structure extends into the second-type region. A first conductor is on the first-type region. A second conductor is on the second-type region. A first gate structure is on the semiconductor layer between the first and second conductor. The first gate structure includes semiconductive layers that are vertically spaced from each other and a first gate metal that contacts the semiconductive layers. A second gate structure is on the semiconductor layer between the first gate structure and the second conductor. The second gate structure includes semiconductive layers that are vertically spaced from each other. The second gate structure further includes a second gate metal that contacts the semiconductive layers of the second gate structure.

## Description

### BACKGROUND

Integrated circuit device scaling reductions increasingly require adoption of different field effect transistor (FET) device designs. Where initially complementary metal oxide semiconductor (CMOS) transistors were planar gate designs, smaller device design nodes moved to so-called "FinFET" designs in which the gate electrode was fabricated to surround a three-dimensional, fin-shaped semiconductor channel structure for improved control and performance. However, for device design nodes below the 3 to 5 nm node, even FinFET designs face problems in control and performance. In view of such issues, new device designs, referred to as gate-all-around (GAA) designs, have been developed and adopted for smaller nodes by several companies. In a GAA design, the gate electrode is fabricated to surround individually stacked semiconductor sheets (nanosheets) or wires (nanowires) on all sides (in cross-section at least). The nanosheets or nanowires then serve as a controllable/switchable channel for current flow. The number and sizing of stacked nanosheets/nanowires can be set according to device design needs. However, there is generally a limit on how long nanosheets/nanowires can extend between supporting structures without collapse during fabrication since current methods use a removal/replacement method in which a "sacrificial" layer is initially formed between adjacent stacked sheets/wires then removed, leaving temporarily an open gap/space between sheet/wires, which is then filled with the gate electrode material.

These GAA designs have many uses and applications, but some devices and applications might be better addressed by a distinct transistor design, such as a lateral drain metal oxide semiconductor (LDMOS) transistor design. For example, certain high voltage applications may require long channel lengths not easily provided by GAA designs due the sheet/wire collapse concern during fabrication. Additionally, some integrated circuit designs might require a mix of GAA-type transistors and LDMOS-type transistors within the same die/chip. In any event, it would be useful to be able to provide LDMOS transistors via a process flow substantially similar to those presently used for GAA designs since GAA-related process flows are generally the most advanced within current fabrication facilities.

### SUMMARY

In an embodiment, a transistor includes a first-type region of a semiconductor layer and a second-type region of the semiconductor layer. The second-type region is adjacent to the first-type region in a first direction. An insulating structure extends from a surface of the semiconductor layer into the second-type region in a second direction that is orthogonal, or substantially so, to the surface. A first conductor is on the surface of the semiconductor layer in the first-type region. A second conductor is on the surface of the semiconductor layer in the second-type region. There is a first gate structure on the surface of semiconductor layer between the first conductor and the second conductor in the first direction. The first gate structure includes a first plurality of semiconductive layers that are spaced from each other in the second direction. The first gate structure further includes a first gate metal that contacts the first plurality of semiconductive layers. A second gate structure is on the surface of the semiconductor layer between the first gate structure and the second conductor in the first direction. The second gate structure includes a second plurality of semiconductive layers that are spaced from each other in the second direction. The second gate structure further includes a second gate metal that contacts the second plurality of semiconductive layers.

In another embodiment, a lateral-drain-metal-oxide-semiconductor transistor includes a p-type region and a n-type region of a semiconductor layer. The n-type region is adjacent to the p-type region in a first direction. A shallow trench insulating structure extends from a surface of the semiconductor layer into the n-type region in a second direction that is orthogonal, or substantially so, to the surface. A source electrode is on the surface of the semiconductor layer in the p-type region. A drain electrode is on the surface of the semiconductor layer in the n-type region. A first gate structure is on the surface of semiconductor layer between the source electrode and the drain electrode in the first direction. The first gate structure includes a first plurality of semiconductive layers spaced from each other in the second direction and a first gate metal that contacts the first plurality of semiconductive layers. A second gate structure is on the surface of the semiconductor layer between the first gate structure and the drain electrode in the first direction. The second gate structure includes a second plurality of semiconductive layers spaced from each other in the second direction and a second gate metal that contacts the second plurality of semiconductive layers. The second gate metal is between each otherwise adjacent pair of semiconductive layers in the second plurality of semiconductive layers in the second direction.

In an embodiment, a transistor includes a semiconductor layer with a first-type region and a second-type region that is adjacent to the first-type region in a first direction. An insulating structure extends from a surface of the semiconductor layer into the second-type region in a second direction that is orthogonal, or substantially so, to the surface. A first electrode is on the surface of the semiconductor layer in the first-type region. A second electrode is on the surface of the semiconductor layer in the second-type region. A first gate structure is on the surface of semiconductor layer between the first electrode and the second electrode in the first direction. The first gate structure has a first plurality of semiconductive layers and a first gate metal. The first plurality of semiconductive layers is spaced from each other in the second direction. Each semiconductive layer of the first plurality of semiconductive layers contacts the first electrode. A second gate structure is on the surface of the semiconductor layer between the first gate structure and the second electrode in the first direction. The second gate structure has a second plurality of semiconductive layers spaced from each other in the second direction and a second gate metal surrounding each of the second plurality of semiconductive layers.

As used in the present disclosure, terms such as "has," "with," "includes," or "including," when used in a manner such as component X has/with/includes component Y, is non-exclusive and open-ended so as to indicate component X comprises components Y such that other aspects, components, or elements other than component Y may also be a part of component X. Similarly, when an element is referred to herein as being "connected" or "coupled" to another element, it is to be understood that the elements can be directly connected to the other element, or have intervening elements present between the elements. In contrast, when an element is specifically referred to as being "directly connected" or "directly coupled" to another element, it should be understood that no intervening elements are present in the "direct" connection or coupling between the elements. However, the existence of a direct connection does not exclude other connections in which intervening elements may be present. Likewise, when an element is referred to herein as being "disposed on" or "on" another element, it is to be understood that such an element can be directly bonded to, mounted on, disposed on, or on the other element (without any intervening elements) or have intervening elements present between the bonded, mounted, or disposed elements. Similarly, when an element is said to be "contacting," "in contact with," or "connected to" another element, intervening elements may be present therebetween or the like. In contrast, when an element is referred to as being "directly on," "directly connected to," "directly disposed on," or "directly contacting" another element, it should be understood that no intervening elements are present. Reference to "electrical connection" of components or "electrically connected" components encompasses direct physical/electrical connections between components as well as indirect electrical connections via other conductive components. For example, electrical connection between two components may be provided by wiring, wires, a conductive path (whether temporary or permanent), electrodes, conductors, leads, vias, terminals, or contacts, alone or in combination.

In general, the drawings are schematic and, as such, the depicted dimensions, relative dimensions, ratio of components, specific positioning of components relative to one another, and the like may have been selected for convenience of description and/or representational clarity and are not to be considered limitations unless specifically noted as such. Likewise, aspects may have been omitted from the depictions for the same or similar reasons related to convenience of description and/or representational clarity. Such additional aspects may be present in an actual implementation without departing from the present disclosure.

### BRIEF DESCRIPTION OF THE DRAWINGS

Fig. 1A depicts a schematic cross-sectional view of a partially fabricated structure at one point in a GAA-type fabrication process.
Fig. 1B depicts a schematic cross-sectional view of a partially fabricated structure at another point in a GAA-type fabrication process.
Fig. 2A depicts a schematic cross-sectional view of a portion of a dual-gate LDMOS transistor design of a first embodiment.
Fig. 2B depicts a schematic flow of current in a dual-gate LDMOS transistor design of a first embodiment.
Fig. 3A depicts a schematic cross-sectional view of a portion of a dual-gate LDMOS transistor design of a second embodiment.
Fig. 3B depicts a schematic flow of current in a dual-gate LDMOS transistor design of a second embodiment.
Fig. 4 depicts a schematic cross-sectional view of a dual-gate LDMOS transistor of a third embodiment.
Fig. 5 depicts a schematic cross-sectional view of a dual-gate LDMOS transistor of a fourth embodiment

### DETAILED DESCRIPTION

### Gate-All-Around Type Process Flow and Structures

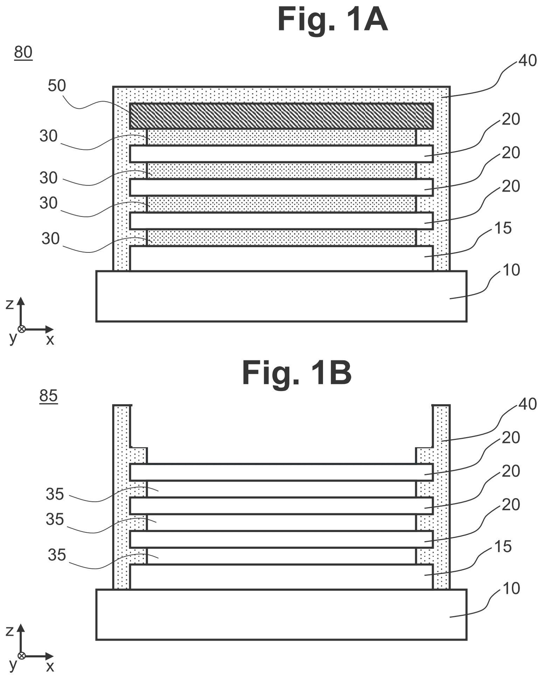

Fig. 1A and Fig. 1B depict aspects of a process flow for fabrication of GAA transistors. The process flow for fabricating a GAA device involves several steps of which only those particularly relevant to the present disclosure are depicted. At one point in the GAA process flow, semiconductor sheets 20 ("sheets 20") are stacked one upon the other with spacer layers 30 ("spacers 30") therebetween. That is, within the stack, sheets 20 alternate with spacers 30. In Fig. 1A, the stack is shown formed on a base layer 15, which is on a substrate 10. A dummy gate 50 is formed on top of the stack. As depicted in Fig. 1A, the uppermost (in z-axis direction) layer in the stack is a spacer 30, upon which the dummy gate 50 is formed. In other examples, the uppermost layer in the stack may be a sheet 20.

A outer spacer 40 surrounds, in the depicted xz plane, the stack and dummy gate 50. Portions of outer spacer 40 are also present at the outer ends of spacers 30, which are recessed somewhat from the outermost ends of the sheets 20 in the x-axis direction. That is, a portion of outer spacer 40 is between the end portions of otherwise adjacent sheets 20. Similarly, a portion of outer spacer 40 is between the end portion of the uppermost sheet 20 of the stack and the dummy gate 50, and another portion of outer spacer 40 is between the end portion of the lowermost sheet of the stack and the base layer 15.

In the present example, sheets 20 are a semiconductive material such as silicon (Si) or, more particularly, monocrystalline silicon. The sheets 20 may be silicon layers, that is, layers formed of a silicon material. The sheets 20 may be referred to as semiconductive layers in some contexts. The spacers 30 are another material, distinct from that of sheets 20. For example, spacers 30 may be silicon-germanium (SiGe), that is, layers formed of a silicon-germanium material, when sheets 20 are silicon layers. In some examples, sheets 20 may be SiGe layers with a different (for example, lesser) germanium content than the spacers 30. The stack of sheets 20 and spacers 30 may be referred to as a superlattice structure in some contexts.

The substrate 10 and base layer 15 may be formed of the same material as the sheets 20, for example, silicon; however, substrate 10 and base layer 15 may be materials different from the sheets 20. The substate 10 and base layer 15 may be materials different from each other in some examples. And, as noted above, because the drawings are merely schematic, the dimensions of substrate 10 relative to base layer 15 may vary significantly from that depicted in Fig. 1A.

The outer spacer 40 may be, for example, a material such as silicon nitride (SiN) when spacers 30 are SiGe and sheets 20 are silicon. The dummy gate 50 may be a polycrystalline silicon (poly-Si) material when spacers 30 are SiGe and sheets 20 are monocrystalline silicon. In general, other materials may be adopted as appropriate for these components in view of such things as final device properties and/or manufacturability.

Fig. 1A shows a GAA-type device at a stage of fabrication that may be referred to as a "pre-release" stage. Fig. 1A shows a pre-release structure 80. Fig. 1B shows a GAA-type device at a stage of fabrication that may be referred to as "post-release" stage. Fig. 1B shows a post-release structure 85. In Fig. 1B, what was the pre-release structure 80 of Fig. 1A has been further processed in a manner to form the post-release structure 85. In post-release structure 85, the outer spacer 40 has been opened at a position above the stack and elsewhere. The dummy gate 50 may also be removed in this opening process or subsequently. After opening, the spacers 30 are removed by a exposure to an etchant or etch processing that preferentially removes the material of the spacers 30 as compared to the material of the sheets 20 (and the outer spacer 40). This removal of spacers 30 may be referred to as a "channel release" process.

After removal of spacers 30, gaps 35 (also referred to as "voids" or "spaces") are left between the stacked sheets 20. Ultimately, a gate electrode material (sometimes referred to as a "gate metal") is formed to fill the gaps 35, but until this occurs, sheets 20 are supported only at outer end portions by the still remaining portions of the outer spacer 40. The structural stability/integrity of the individual sheets 20 thus acts as a limit on achievable channel dimensions (channel length) in a GAA-type device. For example, when the length of the sheets 20 along the depicted x-axis dimension becomes too long, the sheets 20 may sag, bend, or break. That is, as the maximum unsupported dimension of a sheet 20 increases, the likelihood of sheet deformations, collapse, breakage, or the like increases, potentially resulting in a fabrication error that may cause the final device to be non-functional. This limitation on maximum channel length in GAA-type devices is one aspect addressed by certain embodiments of the present disclosure.

### Dual Gate LDMOS Designs

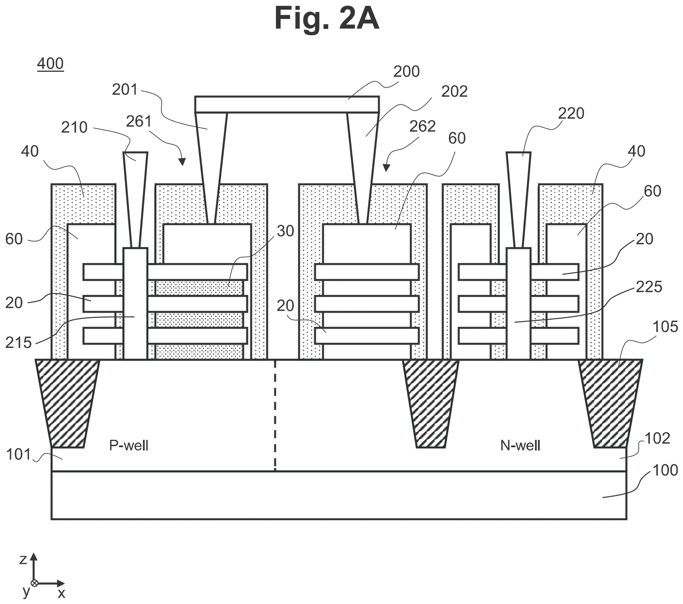

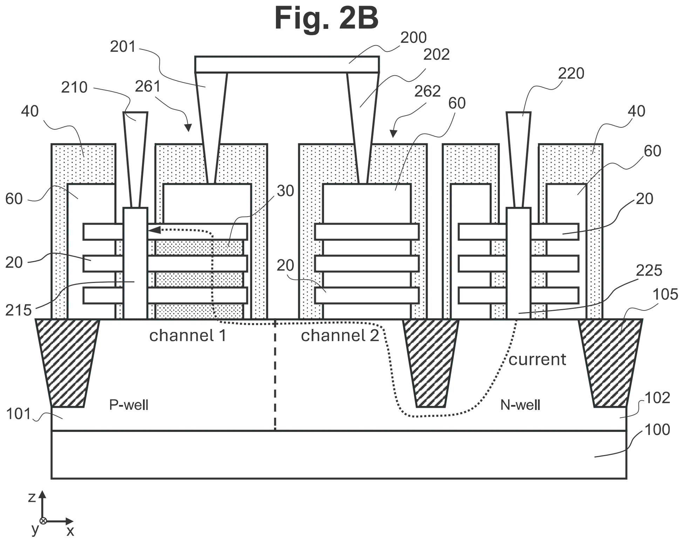

Fig. 2A depicts a schematic cross-sectional view of a portion of a dual-gate LDMOS transistor design of a first embodiment. This design adopts certain structural aspects related to the fabrication of a GAA-type device, but the transistor 400 operates as a LDMOS-type transistor with at least a portion of the transistor channel being within the N-well region 102 and/or P-well region 101 on a substrate 100 rather than being contained entirely or primarily within sheets 20, as would be the case in a regular GAA-type device. See Fig. 2B, depicting current flow (channel formation) in the transistor 400.

Transistor 400 includes various structures that can be formed by GAA-type process flows or by relatively minor variations thereof. For example, in transistor 400, a first gate structure 261 ("first gate 261"), contacted by gate contact 201, includes both spacers 30 and sheets 20, along with a portion of a gate metal 60. Such a structure may be formed by not processing the superlattice stack (see Fig. 1A) to remove spacers 30. For example, simply not opening the outer spacer 40 in a position corresponding to the first gate 261 prior to performing the spacer removal process (see Fig. 1B), leaves the spacers 30 in place in a GAA process flow. A second gate structure 262 ("second gate 262), contacted by gate contact 202, includes sheets 20 surrounded by a portion of gate metal 60 in a manner structurally similar to a regular GAA-type device (however, note, the sheets 20 ends in the second gate 262 do not connect directly to a source/drain structure and the second gate 262 functions more along the lines of a planar-type gate in operation). The second gate 262 is thus processed in a more standard GAA-type processing in which the initially present spacers 30 are removed, then the voids (see Fig. 1B) left by this removal are filled with gate metal 60. In some examples, a gate oxide or dielectric material may be present between the second gate 262 and underlying semiconductor layer (e.g., N-well 102).

In transistor 400, the first gate 261 and the second gate 262 are electrically connected by gate connector 200, and thus the gate voltage for each gate in the dual gate structure is controlled to be substantially the same. Thus, when a sufficient gate voltage is applied to the gate connector 200, a conductive channel (see Fig. 2B) permitting a current to flow between drain electrode 225 and source electrode 215 is formed within transistor 400. That is, when transistor 400 is in the "on-state," current is permitted to flow between drain contact 220 (electrically contacting drain electrode 225) and source contact 210 (electrically contacting source electrode 215). In the "off-state," such current flow is substantially cutoff as the channel is not provided.

Transistor 400 includes shallow trench insulators (STI) 105. These structures are insulating material, such as silicon oxide or the like, formed in the semiconductor material of the P-well 101 and the N-well 102. Such STI structures may also be referred to as "shallow trench isolation" structures in some contexts or examples. The depth, positioning, and shape of the depicted STIs 105 is merely a descriptive example, and such depicted aspects are non-limiting. In general, a STI 105 may be provided at positions beyond the outermost planar positions of the drain electrode 225 and source electrode 215 to provide electrical isolation from adjacent transistors and other components formed on the same substrate 100 along with transistor 400. While depicted in cross-section as two separate components, the outermost STIs 105 may be portions of the same structure, such as a ring, a frame, a grid pattern, or the like, that when viewed from overhead, surrounds the transistor 400. The STI 105 shown positioned in N-well 102 between second gate 262 and drain electrode 225 is provided to limit "punchthrough" and the like during transistor operation. For example, this STI 105 increases the voltage drop path so that the LDMOS drain side can sustain a higher voltage without breaking the gate high K dielectric or gate oxide material. The STIs 105 may be different from one another in various aspects such as depth, shape, lateral width, material, or otherwise.

Fig. 2B depicts a schematic flow of current in a dual-gate LDMOS transistor design of a first embodiment. In particular, Fig. 2B shows an on-state of a transistor 400. While in the on-state, the first gate 261 can be considered in this description to provide a current channel (channel 1) that passes from P-well 101 in a vertical (z-axis) direction and a horizontal (x-axis) direction through sheets 20 to source electrode 215 connected to the sheets 20 within the first gate 261. The second gate 261 can be considered in this description to provide a current channel (channel 2) within the N-well 102 primarily in a horizontal (lateral) direction from the drain electrode 225 to channel 1, but the presence of the interior STI 105 limits current flow in a direct horizontal direction between the second gate 262 and the drain electrode 225.

As mentioned, while structurally the second gate 262 includes sheets 20 (semiconductor material) within, the source/drain current channel does not pass through these sheets 20 and the second gate 262 operates similarly to a planar gate to provide a current channel within the underlying N-well 102.

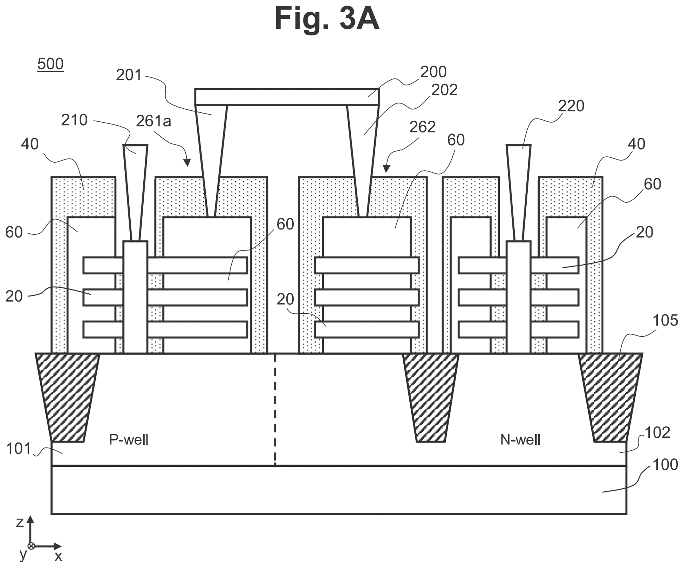

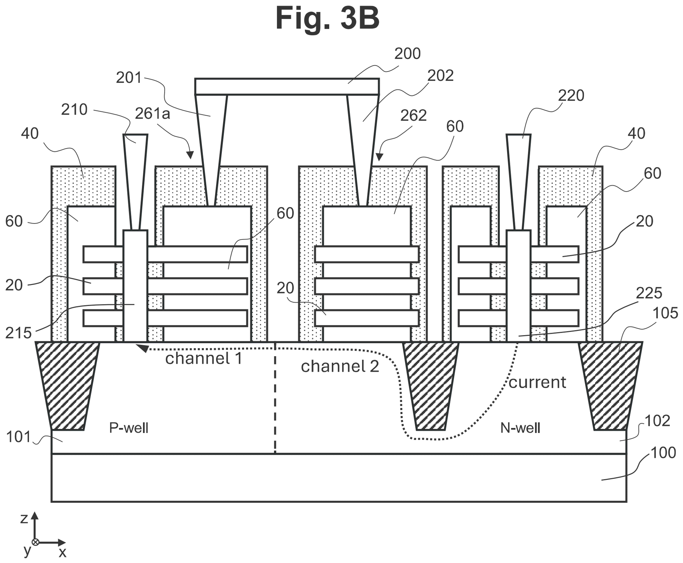

Fig. 3A depicts a schematic cross-sectional view of a portion of a dual-gate LDMOS transistor design of a second embodiment. This design adopts certain structural aspects related to the fabrication of a GAA-type device, but the transistor 500 operates as a LDMOS-type transistor with at least a portion of the transistor channel being within the N-well region 102 and/or P-well region 101 rather than being contained entirely or primarily within sheets 20, as would be the case in a regular GAA-type device. See Fig. 3B, depicting current flow (channel formation) in the transistor 500.

Transistor 500 includes various structures that can be formed by GAA-type process flows or by minor variations thereof. In transistor 500, a first gate structure 261a ("first gate 261a"), contacted by gate contact 201, and a second gate structure 262 ("second gate 262), contacted by gate contact 202, both include sheets 20 surrounded by a portion of gate metal 60 in a manner structurally similar to a regular GAA-type device. In contrast to transistor 400, described above, neither gate structure in transistor 500 includes spacers 30 therein. That is, each gate structure in transistor 500 is a post-release GAA-type structure in which spacers 30 have been removed and replaced by gate metal 60.

While transistor 400 and transistor 500 may each have certain comparative advantages in different applications, one consideration in selection between the two may relate to the intended lateral (horizontal) sizing of the first gate 261/261a and fabrication process limitations related to the release process. As noted, as the planar dimensions of the sheets 20 increase, collapse, breakage, and the like are more likely to occur once the spacers 30 are removed.

In transistor 500, the first gate 261a and the second gate 262 are electrically connected by gate connector 200, and thus the gate voltage for each of gate of the dual gate structure is controlled together. Thus, when a sufficient gate drive voltage is applied to the gate connector 200, a conductive channel (see Fig. 3B) permitting a current to flow between drain electrode 225 and source electrode 215 is formed within transistor 500. That is, when transistor 500 is in the "on-state," current is permitted to flow between drain contact 220 (electrically contacting drain electrode 225) and source contact 210 (electrically contacting source electrode 215). In the "off-state," the current is substantially cutoff as the conductive channel is not formed.

Transistor 500 includes shallow trench insulators (STI) 105. As noted, these structures are insulating material, such as silicon oxide or the like. The depth, positioning, and shape of the depicted STIs 105 in Fig. 3A is merely a descriptive example, and such depicted aspects are non-limiting. In general, a STI 105 may be provided at positions beyond the outermost planar positions of the drain electrode 225 and source electrode 215 to provide electrical isolation from adjacent transistors and other components formed on the same substrate 100 with transistor 500. While depicted in cross-section as two separate components, the outermost STIs 105 may be portions of the same structure, such as a ring, a frame, a grid pattern, or the like. The STI 105 shown positioned in N-well 102 between second gate 262 and drain electrode 225 is provided to limit "punchthrough" and the like. For example, this STI 105 increases the voltage drop path so that the LDMOS drain side can sustain a higher voltage without breaking the gate high K dielectric or gate oxide material. The STIs 105 may be different from one another in various aspects such as depth, lateral width, material, or otherwise.

Fig. 3B depicts a schematic flow of current in a dual-gate LDMOS transistor design of a second embodiment. In particular, Fig. 3B shows an on-state of a transistor 500. While in the on-state, first gate 261a can be considered in this description to provide a current channel (channel 1) that is primarily in the P-well 101. Channel 1 is a horizontal (lateral) channel, and, unlike in transistor 400, channel 1 does not specifically incorporate or include any of the sheets 20 within the first gate 261a. The second gate 261 can be considered in this description to provide a current channel (channel 2) within the N-well 102 primarily in a horizontal (lateral) direction from the drain electrode 225 to channel 1, but the presence of the interior STI 105 limits current flow in a direct horizontal direction between the second gate 262 and the drain electrode 225 and the current must flow around (below) this STI 105. The second gate 262 again operates like a planar gate to provide a current channel within the underlying N-well 102 and sheets 20 within the second gate 262 are not incorporated as part of channel 2. In some examples, a gate oxide or dielectric material may be present between the first gate 261a and underlying semiconductor layer (e.g., P-well 101). In some examples, a gate oxide or dielectric material may be present between the second gate 262 and underlying semiconductor layer (e.g., N-well 102).

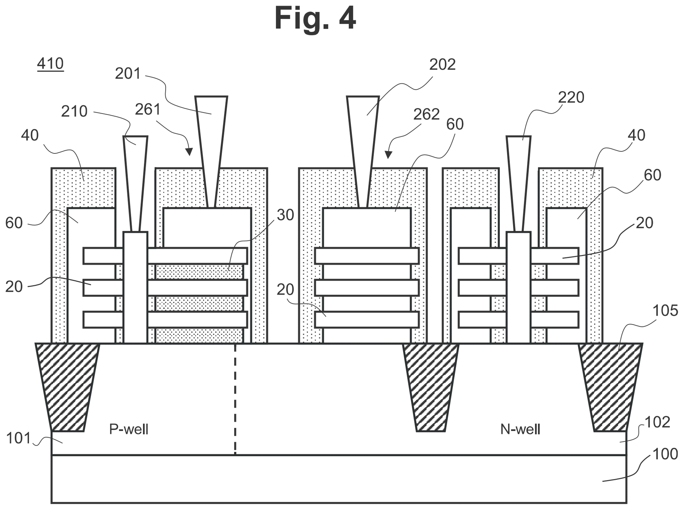

Fig. 4 depicts a schematic cross-sectional view of a dual-gate LDMOS transistor of a third embodiment. In particular, Fig. 4 depicts a transistor 410. Transistor 410 is similar to transistor 400 in several respects but represents certain variations and/or modifications thereof. For example, transistor 410 lacks a gate connector 200, thus the first gate 261 and second gate 262 may be controlled separately. That is, a different voltage may be applied to the first gate 261 as compared to the second gate 262 in some examples. In addition, or instead, the timing of gate voltage application may be different for each gate. Thus, the first gate 261 and the second gate 262 are capable of being independently driven.

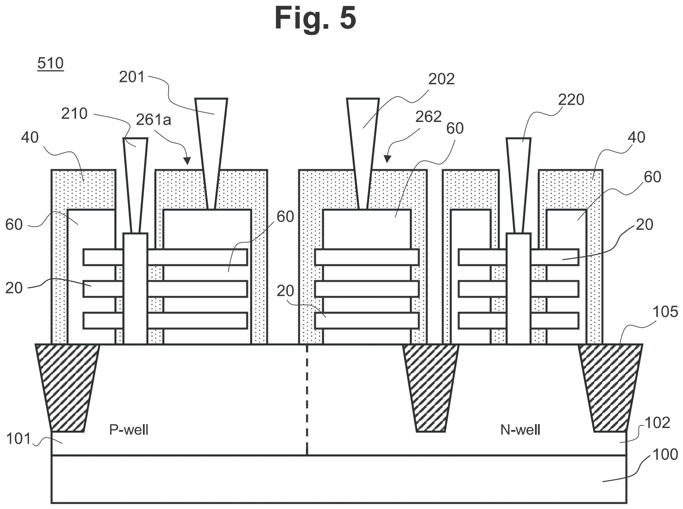

Also shown as a difference between transistor 410 and transistor 400 is the positioning of the notional boundary/border between P-well 101 and N-well 102. In transistor 400, the boundary is at position between first gate 261 and second gate 262. In transistor 410, the boundary is at a position below the first gate 261. However, it should be noted that typically the P-well 101 and the N-well 102 are regions within the same semiconductive material with only regional differences in doping (e.g., dopant type and/or implanted dopant concentrations) serving to establish the different regions (wells). As such, identification of a specific boundary between the regions is somewhat arbitrary in view of such things as dopant diffusion, net concentrations, measurement difficulties and the like. However, the boundary positioning may still be adopted as one of multiple design variables that may affect the performance and behavior of a transistor 410 or the like. Thus, in other embodiments, the boundary position may be different from those depicted in these drawings. For example, in a transistor otherwise similar to transistor 400 or transistor 410, the boundary position may be below the second gate 262 (see, for example, Fig. 5).

Fig. 5 depicts a schematic cross-sectional view of a dual-gate LDMOS transistor of a fourth embodiment. In particular, Fig. 5 depicts a transistor 510. Transistor 510 is similar to transistor 500 in several respects but represents certain variations and/or modifications thereof. For example, transistor 510 lacks a gate connector 200, thus the first gate 261a and second gate 262 may be controlled separately. That is, a different voltage may be applied to the first gate 261a as compared to the second gate 262 in some examples. In addition, or instead, the timing of gate voltage application may be different for each gate. Thus, the first gate 261a and the second gate 262 are capable of being independently driven.

Also shown as a difference between transistor 510 and transistor 500 is the positioning of the notional boundary/border between P-well 101 and N-well 102. In transistor 500, the boundary is at position between first gate 261a and second gate 262. In transistor 510, the boundary is at a position below the second gate 261a. However, as discussed above, typically the P-well 101 and the N-well 102 are regions within the same semiconductive material with only regional differences in doping (e.g., dopant type and/or implanted dopant concentrations) serving to establish the different regions (wells). As such, identification of a specific boundary between the regions is somewhat arbitrary in view of such things as dopant diffusion, net concentrations, measurement difficulties and the like. However, the boundary positioning may still be adopted as one of multiple design variables that may affect the performance and behavior a transistor 510 or the like. Thus, in other embodiments, the boundary position may be different from the specific ones depicted in these drawings. For example, in a transistor otherwise similar to transistor 500 or transistor 510, the boundary position may be below the first gate 261a (see, for example, Fig. 4).

In certain non-limiting examples, a transistor 400, a transistor 410, a transistor 500, or a transistor 510 may have a first gate 261 (or first gate 261) with a lateral dimension (x-axis dimension) of around 150 nm or less and a second gate 262 with a lateral dimension (x-axis dimension) of around 100 nm or less. Such transistors may be used in some examples as a high voltage LDMOS transistor with a source/drain differential of 0.75 V or more. The processing adopted for fabrication of a transistor 400, a transistor 410, a transistor 500, or a transistor 510 may be, for example, a sub-5 nm node process otherwise utilized for fabrication of a GAA-type transistor or device, but is not limited thereto. In other non-limiting examples, the processing adopted may be a 2 nm node process otherwise utilized for fabrication of a GAA-type transistor or device.

An integrated semiconductor circuit device may incorporate one or more transistor 400, one or more transistor 410, one or more transistor 500, and/or one or more transistor 510. That is, the described transistors may be used in combination with any other of the described transistors. Likewise, the described transistors may be used in combination with other types of transistors (such as a GAA transistor) and/or other circuit components (such as resistors and capacitors). Connections between such transistors and circuit components may be made in any manner feasible, such as via wiring in one or more levels at or above the level of gate connector 200 or at or above the level at which source contact 210 and drain contact 220 terminate.

While depicted examples show source contact 210 and drain contact 220 terminating at a position lower than that of first gate contact 201 and second gate contact 202, such is not necessarily required and the levels may be the same, or the source contact 210 and/or drain contact 220 may terminate at a level higher than that of the gate contacts.

In general, the material(s), shape(s), and/or size(s) used for the various contacts and connectors are not limited so long as such material is sufficiently conductive and the shape and size permit sufficient current to flow without intolerable electrical resistance.

In general, while not specifically labeled in the drawings, an insulating material covers, and is in the spaces between, the depicted components. For example, an interlayer dielectric would typically be present between gate connector 200 and the other components besides the connected gate contacts.

The source electrode 215 and the drain electrode 225 may generally be made in a manner similar electrodes are made for a GAA-type transistor. Likewise, the various contacts can be made in a manner similar to contacts in a GAA-type transistor. As depicted, drain electrode 225 passes through a plurality of sheets 20, but these sheets are not physically connected to the second gate 262. The electrical separation between the second gate 262 and the sheets 20 associated with drain electrode 225 may be provided in various manners, and the drain electrode 225 may be offset from a center or midpoint of the associated sheets 20.

In the specifically depicted examples, the source electrode 215 directly contacts the sheets 20 of the first gate 261. In designs like transistor 400 and transistor 410, such contact is generally required as the current channel in part passes laterally through these sheets 20. However, in some variations, not all sheets 20 of the first gate 261 need to contact the source electrode 215 and it may be sufficient for less than all such sheets 20 to contact the source electrode 215 so long a lateral current channel is provided sufficiently by the sheets 20 that do contact the source electrode 215. In designs like transistor 500 and transistor 510, it may not be necessary for any sheets 20 of the first gate 261a to contact the source electrode 215 since the current channel passes laterally through the underlying semiconductor layer (e.g., P-well 101) to the source electrode 215 without passing through any of the sheets 20 of the first gate 261a.

While certain described examples refer to a source electrode 215 and a drain electrode 220, this naming convention is generally applied for descriptive convenience. In various embodiments, the source electrode 215 may electrically function as "a drain" in a particular circuit design, and the drain electrode 220 may electrically function as "a source" without departing from the scope of the present disclosure.

The N-well 102 and the P-well 101 may be sub-portions of substrate 100. For example, substrate 100 may be a silicon wafer (or portion thereof), and the N-well 102 and the P-well 101 may be doped regions of substrate 100. In such cases, a discrete lower boundary between the wells and substrate 100 may not be readily apparent upon examination. In other examples, substrate 100 may be an entirely different material from N-well 102 and P-well 101. For example, substrate 100 may be, or comprise, an insulating material, and the semiconductor material of N-well 102 and P-well 101 may be deposited, grown, or otherwise formed on a surface of substrate 100.

Although one or more embodiments of the present disclosure have been described in some detail for clarity of understanding, certain changes may be made and still be within the scope of the claims. Accordingly, the described embodiments are to be considered as illustrative and not restrictive or limiting, and the scope of the claims is not to be considered limited to details given herein but may be modified while still being within the scope of the claims and equivalents. In the claims, any recitation of elements and/or steps do not imply any particular order of operation or incorporation unless explicitly stated in the claims.

Depicted boundaries between components, elements, devices, and units are somewhat arbitrary, and while particular boundaries may have been illustrated in the context of specific example configurations, other boundaries, divisions, and/or allocations of functions, components, elements, or aspects may be possible or available. Such other allocations of functionality and/or components are envisioned and should be considered to fall within the scope of the present disclosure. In general, structures and functionalities presented as separate components in exemplary configurations may be implemented as a combined structure or component. Similarly, structures and functionalities presented as a single component may be implemented as separate components. These and other variations, additions, alterations, and improvements may fall within the scope of the appended claims.

## Claims

1. A transistor, comprising:
a first-type region of a semiconductor layer;
a second-type region of the semiconductor layer, the second-type region being adjacent to the first-type region in a first direction;
an insulating structure extending from a surface of the semiconductor layer into the second-type region in a second direction orthogonal to the surface;
a first conductor on the surface of the semiconductor layer in the first-type region;
a second conductor on the surface of the semiconductor layer in the second-type region;
a first gate structure on the surface of semiconductor layer between the first conductor and the second conductor in the first direction, the first gate structure including a first plurality of semiconductive layers spaced from each other in the second direction and a first gate metal contacting the first plurality of semiconductive layers; and
a second gate structure on the surface of the semiconductor layer between the first gate structure and the second conductor in the first direction, the second gate structure including a second plurality of semiconductive layers spaced from each other in the second direction and a second gate metal contacting the second plurality of semiconductive layers.

2. The transistor according to claim 1, wherein
the first gate structure includes a plurality of spacer layers between the first plurality of semiconductive layers.

3. The transistor according to claim 2, wherein
the second gate metal is between each otherwise adjacent pair of semiconductive layers in the second plurality of semiconductive layers in the second direction.

4. The transistor according to any one of the claims 1 to 3, wherein
the first gate metal is between each otherwise adjacent pair of semiconductive layers in the first plurality of semiconductive layers in the second direction.

5. The transistor according to claim 4, wherein
the second gate metal is between each otherwise adjacent pair of semiconductive layers in the second plurality of semiconductive layers in the second direction.

6. The transistor according to any one of the claims 1 to 5, wherein
the first and second gate structures are electrically connected.

7. The transistor according to any one of the claims 1 to 6, wherein
the first plurality of semiconductive layers contact the first conductor.

8. The transistor according to any one of the claims 1 to 7, wherein
a boundary between the first-type region and the second-type region is at a position between the first gate structure and the second gate structure.

9. A lateral-drain-metal-oxide-semiconductor transistor, comprising:
a p-type region of a semiconductor layer;
a n-type region of the semiconductor layer, the n-type region being adjacent to the p-type region in a first direction;
a shallow trench insulating structure extending from a surface of the semiconductor layer into the n-type region in a second direction orthogonal to the surface;
a source electrode on the surface of the semiconductor layer in the p-type region;
a drain electrode on the surface of the semiconductor layer in the n-type region;
a first gate structure on the surface of semiconductor layer between the source electrode and the drain electrode in the first direction, the first gate structure including a first plurality of semiconductive layers spaced from each other in the second direction and a first gate metal contacting the first plurality of semiconductive layers; and
a second gate structure on the surface of the semiconductor layer between the first gate structure and the drain electrode in the first direction, the second gate structure including a second plurality of semiconductive layers spaced from each other in the second direction and a second gate metal contacting the second plurality of semiconductive layers and between each otherwise adjacent pair of semiconductive layers in the second plurality of semiconductive layers in the second direction.

10. The lateral-drain-metal-oxide-semiconductor transistor according to claim 9, wherein
the first gate structure includes a plurality of spacer layers between the first plurality of semiconductive layers.

11. The lateral-drain-metal-oxide-semiconductor transistor according to claim 10, wherein each semiconductive layer is a silicon layer, and
the plurality of spacer layers are silicon-germanium layers.

12. The lateral-drain-metal-oxide-semiconductor transistor according to claim 11, wherein
a boundary between the p-type region and the n-type region is at a position between the first gate structure and the second gate structure;
wherein in particular
the first and second gate structures are electrically connected.

13. The lateral-drain-metal-oxide-semiconductor transistor according to any one of the claims 9 to 12, wherein
the first gate metal is between each otherwise adjacent pair of semiconductive layers in the first plurality of semiconductive layers in the second direction.

14. A transistor, comprising:
a first-type region of a semiconductor layer;
a second-type region of the semiconductor layer, the second-type region being adjacent to the first-type region in a first direction;
an insulating structure extending from a surface of the semiconductor layer into the second-type region in a second direction orthogonal to the surface;
a first electrode on the surface of the semiconductor layer in the first-type region;
a second electrode on the surface of the semiconductor layer in the second-type region;
a first gate structure on the surface of semiconductor layer between the first electrode and the second electrode in the first direction, the first gate structure having a first plurality of semiconductive layers and a first gate metal, the first plurality of semiconductive layers being spaced from each other in the second direction, each semiconductive layer of the first plurality of semiconductive layers contacting the first electrode; and
a second gate structure on the surface of the semiconductor layer between the first gate structure and the second electrode in the first direction, the second gate structure including a second plurality of semiconductive layers spaced from each other in the second direction and a second gate metal surrounding each of the second plurality of semiconductive layers.

15. The transistor according to claim 14, comprising at least one of the following features:
(A) the first gate structure includes silicon-germanium layers between each adjacent pair of semiconductive layers of the first plurality of semiconductive layers in the second direction;
(B) the first gate metal is between each adjacent pair of semiconductive layers of the first plurality of semiconductive layers in the second direction;
(C) the first gate structure and the second gate structure are electrically connected; and
(D) the second electrode extends in the second direction through a third plurality of semiconductive layers spaced from each other in the second direction.
